# EUROPEAN PATENT SPECIFICATION

(11) **EP 4 080 228 B1**
(45) Date of publication and mention of the grant of the patent: **20.12.2023**
(21) Application number: 21464001.3
(22) Date of filing: 29.09.2021
(51) Int. Cl.: G01R 31/08, G01R 19/165

(54) **ELECTRICAL NETWORK FAULT SIGNALLING DEVICE**
VORRICHTUNG ZUR SIGNALISIERUNG EINES FEHLERS IN ELEKTRISCHEM NETZ
DISPOSITIF DE SIGNALISATION DE PANNE DE RÉSEAU ÉLECTRIQUE

(30) Priority: 23.04.2021 RO 202100199
(43) Date of publication of application: 26.10.2022
(73) Proprietor: Stefan cel Mare University of Suceava, 720229 Suceava, County Suceava (RO)
(72) Inventor: Tanta, Ovidiu Magdin, Suceava, jud. Suceava (RO); Paval, Mihaela, com. Pojorâta, sat. Valea Putnei, jud. Suceava (RO); Milici, Dan Laurentiu, sat Lisaura, comuna Ipotesti, jud. Suceava (RO); Grosu, Oana Vasilica, com. Adâncata, sat Adâncata, jud. Suceava (RO); Toader, Vasile-Eusebiu, mun. Suceava, Jud. Suceava (RO); Atanasoae, Pavel, com. cheia, sat Sfântu Ilie, jud. Suceava (RO); Popa, Valentin, 720011 Suceava, jud. Suceava (RO)

(56) References cited:
- US-A- 4 064 453
- US-A- 4 529 875
- US-A1- 2013 187 636

## Description

The invention relates to an electrical network fault signalling device, made on the basis of the behavior of the ferrofluid in the electric field, in order to detect the portions of defective power lines.

In order to make some devices for signaling the failure of the electrical network, a series of solutions are known, which consist mainly in the use of indicators that in case of a fault on the line (short circuit or grounding) will behave as follows: all indicators installed between the supplying station and the place of occurrence of the fault will signal optically, intermittently while the indicators located after the fault zone, will remains awake (will not signal). Prior art document US2013/187636 discloses a fault current indicator for overhead power lines, comprising magnetic core halves using ferrofluid to improve coupling between them.

The disadvantages of the solution are related to the construction complexity and the need to use an external power supply for optical signaling devices.

The technical problem solved by the invention consists in the realization of a fault signaling device of the electrical network that uses the magnetic properties of the ferrofluid to determine the appearance of a defect in the network.

The automatic fault signaling device of the electrical network, according to the invention, eliminates the disadvantages presented in that it consists mainly of a tube mounted on the electrical conductor having inside a quantity of ferrofluid that will move in the tube when a defect occurs.

The invention has the following advantages;
- The system does not require additional power;
- Constructive simplicity;
- Precise signaling of the fault zone.

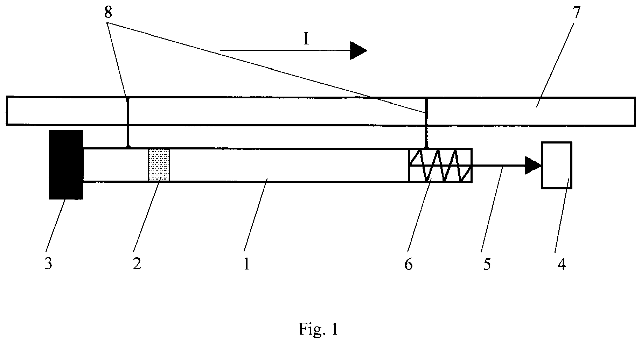

An embodiment of the invention is given below in connection with figure 1 which is an overview of the electrical network fault signalling device.

The automatic fault signaling device of the electrical network, according to the invention, consists mainly of a tube of non-ferromagnetic material 1 having inside a quantity of ferrofluid 2, at one end it is provided with a permanent magnet 3, and at the other end with an indicator element 4 which can be actuated by the piston rod 5 and the spring 6; tube which is fixed by an electrical conductor 7 by means of the electrical insulating fixing support 8.

Under normal network conditions, at rated current I through conductor 7, the ferrofluid 2 is maintained at the left end of the tube 1 by the permanent magnet 3, which is dimensioned according to the value of the rated current through conductor 7. When a fault occurs in the conductor 7, the increase in current causes the ferrofluid 2 to move to the opposite end of the tube 1, where, through the piston rod 5, will be actuated the indicator element 4. The indicator element 4 will signal the passing of the fault current until the manual reset by a mechanical timer. The piston rod 5 is brought to the initial position by the spring 6, and the ferrofluid column 2 returns to the lower end of the tube 1 being attracted by the permanent magnet 3.

The electrical network fault signalling device according to the invention can be reproduced with the same characteristics and performances whenever necessary, which is an argument in favour of respecting the industrial applicability criterion.

## Claims

1. Electrical network fault signalling device comprising a tube of non-ferromagnetic material (1) having a quantity of ferrofluid inside (2), at one end it is provided with a permanent magnet (3), and at the other end with an indicator element (4) actuated by a piston rod (5) and a spring (6); and an electrical insulating fixing support (8) configured to fix the tube to an electrical conductor (7).

2. Electrical network fault signalling device according to Claim 1, **characterized in that** in the case of normal operation, at rated current through the conductor (7), the ferrofluid (2) is maintained at the lower end of the tube (1) by a permanent magnet (3), dimensioned according to the value of the nominal current through the conductor (7), and when a defect occurs in the conductor (7), the increase of the current determines the displacement of the ferrofluid (2) to the opposite end of the tube (1), where, by means of the piston rod (5) actuates the indicator element (4), which will signal the passage of the fault current until the manual reset or the reset given by a mechanical timer, wherein the piston rod (5) is brought to the initial position by the spring (6), and the ferrofluid column (2) returns to the lower end of the tube (1) being attracted by the permanent magnet (3).

## Patentansprüche

1. Elektrisches Netzwerkfehlersignalgerät, das **dadurch gekennzeichnet ist, dass** es hauptsächlich aus einem Röhrchen aus nicht ferromagnetischem Material (1) besteht am anderen Ende mit einem Indikatorelement (4), der von einer Kolbenstange (5) und einer Feder (6) betätigt wurde; und eine elektrische Isolierfixierunterstützung (8), die so konfiguriert ist, dass das Röhrchen mit einem elektrischen Leiter (7) fixiert wird.

2. Elektrische Netzwerkfehlersignalvorrichtung gemäß Anspruch 1, die darin gekennzeichnet ist, dass im Normalbetrieb bei Nennstrom über den Leiter (7) der Ferrofluid (2) am unteren Ende des Rohrs (1) durch gehalten wird Ein permanenter Magnet (3), der nach dem Wert des Nennstroms durch den Leiter (7) dimensioniert ist und wenn ein Defekt im Leiter (7) auftritt, bestimmt die Zunahme des Strom Das entgegengesetzte Ende des Rohrs (1), wobei mit dem Kolbenstab (5) das Indikatorelement (4) betätigt wobei die Kolbenstange (5) durch die Feder (6) in die Anfangsposition gebracht wird, und die Ferrofluid -Säule (2) kehrt zum unteren Ende des Rohrs (1) zurück, das vom permanenten Magneten (3) angezogen wird.

## Revendications

1. Dispositif de signalisation de défauts de réseau électrique, **caractérisé en ce qu'**il est constitué principalement d'un tube en matériau non ferromagnétique (1) comportant une quantité de ferrofluide à l'intérieur (2), à une extrémité il est muni d'un aimant permanent (3), et à l'autre extrémité un élément indicateur (4) actionné par une tige de piston (5) et un ressort (6) ; et un support de fixation électriquement isolant (8) configuré pour fixer le tube à un conducteur électrique (7).

2. Dispositif de signalisation de défauts de réseau électrique selon la revendication 1, **caractérisé en ce qu'**en cas de fonctionnement normal, au courant nominal traversant le conducteur (7), le ferrofluide (2) est maintenu à l'extrémité inférieure du tube (1) par un aimant permanent (3), dimensionné en fonction de la valeur du courant nominal traversant le conducteur (7), et lorsqu'un défaut survient dans le conducteur (7), l'augmentation du courant détermine le déplacement du ferrofluide (2) vers l'extrémité opposée du tube (1), où, au moyen de la tige de piston (5), actionne l'élément indicateur (4), qui signalera le passage du courant de défaut jusqu'au réinitialisation manuel ou au réinitialisation donné par une minuterie mécanique dans lequel la tige de piston (5) est amenée à la position initiale par le ressort (6), et la colonne de ferrofluide (2) revient vers l'extrémité inférieure du tube (1) en étant attirée par l'aimant permanent (3).
